# EUROPEAN PATENT APPLICATION

(11) **EP 4 686 374 A1**
(43) Date of publication of application: **28.01.2026**
(21) Application number: 25191281.2
(22) Date of filing: 23.07.2025
(51) Int. Cl.: H10P 10/00

(54) **DEPOSITION BY ELECTRON ENHANCED PROCESSES WITH POSITIVE SUBSTRATE VOLTAGE**

(30) Priority: 23.07.2024 US 202463674633 P; 21.07.2025 US 202519275176
(71) Applicant: Samsung Electronics Co., Ltd., Suwon-si, Gyeonggi-do 16677 (KR); The Regents of the University of Colorado, a body corporate, Denver, CO 80203 (US)
(72) Inventor: YASMEEN, Sumaira, Denver, CO, 80203 (US); GEORGE, Steven, Denver, CO, 80203 (US); SIMKA, Harsono, San Jose, CA, 95134 (US)
(74) Representative: Kuhnen & Wacker Patent- und Rechtsanwaltsbüro PartG mbB

(57) **Abstract**

A method for depositing a film includes conducting electron-enhanced chemical vapor deposition with at least one hydride precursor, at least one reactive background gas, and electrons to deposit a film on a substrate with a positive substrate voltage. In an embodiment, the method is a method for depositing a silicon film, including conducting electron-enhanced chemical vapor deposition with at least one Si precursor, at least one reactive background gas, and electrons to deposit a silicon film on a substrate with a positive substrate voltage. In the embodiment, the at least one Si precursor can include Si₂H₆ and the at least one reactive background gas can include H₂.

## Description

### BACKGROUND

### 1. Field

Embodiments according to the present disclosure relate to processes for electron-enhanced chemical vapor deposition (EE-CVD).

### 2. Description of the Related Art

In the semiconductor industry, two prevalent methods for film growth are thermal and plasma based atomic layer deposition (ALD) and chemical vapor deposition (CVD). While thermal processes offer some capability for conformal film growth, their drawback lies in the requirement for elevated deposition temperatures, rendering the thermal processes unsuitable for applications with stringent thermal constraints. Conversely, plasma-assisted processes enable the deposition of high-quality films at lower substrate temperatures compared to thermally driven processes; however, there are number of disadvantages associated with plasma assisted processes, such as substrate damage, equipment complexity, contamination, and selectivity.

In the ever-evolving landscape of semiconductor fabrication, the development of, e.g., precise and efficient deposition methods is paramount for advancing electronic devices. Among the innovative techniques gaining prominence are electron-enhanced deposition and processes, such as electron-enhanced atomic layer deposition (EE-ALD) and electron-enhanced chemical vapor deposition (EE-CVD). These processes offer meticulous control over film growth at low temperatures, and the films deposited using these processes are of high quality, and impurity free. However, with these processes, there is a need for increased deposition rates.

In view of the above, there is a need in the art for an improved method for film growth.

Information disclosed in this Background section has already been known to the inventors before achieving the disclosure of the present application or is technical information acquired in the process of achieving the disclosure. Therefore, it may contain information that does not form the prior art that is already known to the public.

### SUMMARY

It is an object of the present disclosure to provide an improved method for film growth.

To meet the above and other objects, the present disclosure employs EE-CVD (Electron-Enhanced Chemical Vapor Deposition), which involves the use of electrons to enable deposition of films on any substrate. An example is EE-CVD of Si. This process allows for deposition of pure Si: (i) at lower temperatures (below the thermal decomposition temperature of silanes), such that the process is back-end-of-line (BEOL) compatible; (ii) without requiring direct plasma; and (iii) without requiring corrosive gases (F, Cl).

Innovative aspects include: electrons (specially tuned) are new reactants, activating gas-phase species near the surface, enabling reactions that do not otherwise occur unless at high temperature or in plasma. For example, an electron-mediated process is provided that allows adsorption of Si₂H₆ through electron-simulated desorption (ESD) of surface hydrogen.

Applications can include Logic 3DSFET, 3D DRAM, NAND, and embedded memory.

EE-CVD uses electrons to enable the deposition of films on a substrate. The process involves the use of a hydride precursor, such as disilane (Si₂H₆), and optionally a reactive background gas, such as hydrogen (H₂), to deposit a film on a substrate.

Aspects of the process of the present disclosure may include (1) preparation of the substrate, (2) introduction of the precursor gas, (3) introduction of the reactive background gas (the reactive background gas is optional in the present disclosure) (4) application of electron energy and positive substrate voltage, and (5) deposition of the film.

Thus, the present disclosure provides a number of embodiments, including the following.

A first embodiment of the present disclosure includes a method for electron-enhanced chemical vapor deposition of a film, including: cleaning and drying a substrate, introducing at least one hydride precursor gas into a reaction chamber containing the substrate, applying electrons to the reaction chamber to dissociate the precursor gas and create reactive species, and depositing a film on the substrate by reacting the reactive species with the substrate, wherein the substrate has a positive substrate voltage.

A second embodiment of the present disclosure includes a method of the first embodiment, further including: introducing at least one reactive background gas into the reaction chamber containing the substrate.

A third embodiment of the present disclosure includes a method of the first embodiment, wherein the method is a method for depositing a silicon film, including: conducting electron-enhanced chemical vapor deposition with at least one Si precursor, at least one reactive background gas, and electrons to deposit a silicon film on a substrate with a positive substrate voltage.

A fourth embodiment of the present disclosure includes a method of the third embodiment, wherein the at least one Si precursor includes Si₂H₆.

A fifth embodiment of the present disclosure includes a method of the third embodiment, wherein the at least one reactive background gas includes H₂.

A sixth embodiment of the present disclosure includes a method of the third embodiment, wherein the at least one Si precursor includes Si₂H₆ and the at least one reactive background gas includes H₂.

A seventh embodiment of the present disclosure includes a method of the first embodiment, wherein the method is a method for depositing a germanium film, including: conducting electron-enhanced chemical vapor deposition with at least one Ge precursor, at least one reactive background gas, and electrons to deposit a germanium film on a substrate with a positive substrate voltage.

An eighth embodiment of the present disclosure includes a method of the seventh embodiment, wherein the at least one Ge precursor includes GeH₄.

A ninth embodiment of the present disclosure includes a method of the seventh embodiment, wherein the at least one Ge precursor includes Ge₂H₆.

A tenth embodiment of the present disclosure includes a method of the seventh embodiment, wherein the at least one reactive background gas includes H₂.

An eleventh embodiment of the present disclosure includes a method of the seventh embodiment, wherein the at least one Si precursor includes GeH₄ and the at least one reactive background gas includes H₂.

A twelfth embodiment of the present disclosure includes a method of the seventh embodiment, wherein the at least one Ge precursor includes Ge₂H₆ and the at least one reactive background gas includes H₂.

A thirteenth embodiment of the present disclosure includes a method of the first embodiment, wherein the method is a method for depositing a compound semiconductor film, including: conducting electron-enhanced chemical vapor deposition with at least two hydride precursors, at least one reactive background gas, and electrons to deposit a compound semiconductor film on a substrate with a positive substrate voltage.

A fourteenth embodiment of the present disclosure includes a method of the thirteenth embodiment, wherein the compound semiconductor film is a silicon germanium film.

A fifteenth embodiment of the present disclosure includes a method of the second embodiment, wherein the method is conducted at room temperature.

A sixteenth embodiment of the present disclosure includes a method of the third embodiment, wherein the method is conducted at room temperature.

A seventeenth embodiment of the present disclosure includes a method of the second embodiment, wherein the positive substrate voltage is up to 100 V.

An eighteenth embodiment of the present disclosure includes a method of the third embodiment, wherein the positive substrate voltage is up to 100 V.

A nineteenth embodiment of the present disclosure includes a method of the first embodiment, wherein the method is a method for depositing a silicon-containing film.

A twentieth embodiment of the present disclosure includes a method of the nineteenth embodiment, wherein the silicon-containing film comprises SiO₂, SiN, SiC, or a combination thereof.

### BRIEF DESCRIPTION OF DRAWINGS

The patent or application file contains at least one drawing executed in color. Copies of this patent or patent application publication with color drawing(s) will be provided by the Office upon request and payment of the necessary fee.

Example embodiments of the present disclosure will be more clearly understood from the following detailed description taken in conjunction with the accompanying drawings in which:
FIG. 1 is flow chart showing the method steps for an exemplary embodiment of the present disclosure.
FIG. 2 shows a diagram of an embodiment of the presently disclosed electron-enhanced chemical vapor deposition process.
FIG. 3 is a schematic diagram showing a V-shaped reactor with a hollow cathode plasma electron source above the sample at the center of the V, wherein spectroscopic ellipsometry connects to the two ends of the V, and pumping ports to either a mechanical pump or turbomolecular pump connect through the 4-way cross.
FIG. 4 is a diagram of the hollow cathode operation in an embodiment of the present disclosure.
FIG. 5 shows increasing collimating coil current, which is a parameter that can affect electron enhanced processes.
FIG. 6 is a schematic diagram showing the hollow cathode generating primary electrons in an embodiment of the present disclosure.
FIG. 7 shows various pathways for electron-enhanced processing in an embodiment of the present disclosure.
FIG. 8 is a schematic diagram depicting a Silicon (Si) EE-CVD process of the present disclosure.
FIG. 9 shows the Si EE-CVD growth on SOI (Si on insulator) in the presence and absence of a positive sample bias.
FIGS. 10A and 10B show schematic diagrams illustrating the experimental setups utilized in Si EE-CVD with and without sample bias, respectively.
FIGS. 11A and 11B illustrate the in-situ ellipsometry thickness for Si EE-CVD film and the XRR of the Si EE-CVD film, respectively.
FIGS. 12A and 12B depict a comprehensive analysis of ~100 nm Si EE-CVD films using X-ray Photoelectron Spectroscopy (XPS) for chemical composition and Elastic Recoil Detection Analysis (ERDA) to quantify the presence of hydrogen (H) within the film, respectively.
FIG. 13 is a graphical representation of Si EE-CVD thickness over time on Si (100), thermal SiO₂, and Si₃N₄ substrates.
FIG. 14 depicts the influence of Si₂H₆ dose time on film growth, illustrating the relationship between thickness and time.
FIG. 15 presents the results of Si EE-CVD conducted at various bias grid voltages.
FIG. 16 illustrates experiments conducted with and without the presence of H₂ RBG.
FIG. 17 shows the Si EE-CVD growth in the presence and absence of Si₂H₆.
FIGS. 18A-18D show the surface profilometry analysis after the Si EE-CVD film deposition.
FIG. 19 shows the Si EE-CVD film grows linearly without any nucleation delay in the presence of just Si₂H₆ and electrons.
FIG. 20 shows an exemplary embodiment of the present disclosure for Si EE-CVD with increasing collimating coil current.
FIG. 21 shows an exemplary embodiment of the present disclosure for Si EE-CVD with increasing bias grid voltage.
FIG. 22 shows a graph of film thickness vs. the number of Si EE-CVD cycles for an exemplary embodiment of the present disclosure.
FIG. 23 shows the XPS depth profile of an exemplary embodiment of the present disclosure.
FIGS. 24A-24C show the surface roughness of various embodiments, including an exemplary embodiment of the present disclosure.
FIG. 25 shows an XRD 2*θ* scan of an exemplary embodiment of the present disclosure.
FIG. 26 shows the significant enhancement of Si EE-CVD with sample voltage for an exemplary embodiment of the present disclosure.
FIG. 27 shows Si EE-CVD with and without D₂ for an exemplary embodiment of the present disclosure.
FIGS. 28A-28C show the use of a stainless-steel mesh mask during Si EE-CVD and the resulting surface profilometry after Si EE-CVD for an exemplary embodiment of the present disclosure.

### DETAILED DESCRIPTION OF EXAMPLE EMBODIMENTS

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future.

Throughout this disclosure, values expressed in a range format should be interpreted in a flexible manner to include not only the numerical values explicitly recited as the limits of the range, but also to include all the individual numerical values or sub-ranges encompassed within that range as if each numerical value and sub-range is explicitly recited. For example, a range of "about 0.1% to about 5%" or "about 0.1% to 5%" should be interpreted to include not just about 0.1% to about 5%, but also the individual values (e.g., 1%, 2%, 3%, and 4%) and the sub-ranges (e.g., 0.1% to 0.5%, 1.1% to 2.2%, 3.3% to 4.4%) within the indicated range. The statement "about X to Y" has the same meaning as "about X to about Y," unless indicated otherwise. Likewise, the statement "about X, Y, or about Z" has the same meaning as "about X, about Y, or about Z," unless indicated otherwise.

In this disclosure, the terms "a," "an," or "the" are used to include one or more than one unless the context clearly dictates otherwise. The term "or" is used to refer to a nonexclusive "or" unless otherwise indicated. The statement "at least one of A and B" or "at least one of A or B" has the same meaning as "A, B, or A and B." In addition, it is to be understood that the phraseology or terminology employed herein, and not otherwise defined, is for the purpose of description only and not of limitation. Any use of section headings is intended to aid reading of the document and is not to be interpreted as limiting; information that is relevant to a section heading may occur within or outside of that particular section.

In the methods described herein, the acts can be carried out in any order, except when a temporal or operational sequence is explicitly recited. Furthermore, specified acts can be carried out concurrently unless explicit claim language recites that they be carried out separately. For example, a claimed act of doing X and a claimed act of doing Y can be conducted simultaneously within a single operation, and the resulting process will fall within the literal scope of the claimed process.

As used herein, unless defined otherwise, all technical and scientific terms generally have the same meaning as commonly understood by one of ordinary skill in the art to which this disclosure belongs. Generally, the nomenclature used herein and the laboratory procedures in surface chemistry are those well-known and commonly employed in the art.

The term "about" as used herein can allow for a degree of variability in a value or range, for example, within 10%, within 5%, or within 1% of a stated value or of a stated limit of a range, and includes the exact stated value or range.

As used herein, the term "CVD" refers to chemical vapor deposition, which is a film deposition method. In certain embodiments, the process of the present disclosure can be used to produce thin films, wherein the term "thin" refers to a range of thickness from about 0.1 nm to about 300 nm. The process of the present disclosure may also produce films having a thickness greater than 300 nm, even on the order of microns or millimeters.

Electrons can provide a non-thermal means to enhance film growth, including at low temperature. In particular, electrons can enhance chemical vapor deposition (CVD) and facilitate CVD at low temperature. There are various factors that influence electron enhanced processing, such as grid bias voltage, biasing the sample stage, effect of H₂ pressure, how electrons interact with certain materials, etc.

Upon incident electron beam interaction of primary electrons with the sample surface, secondary electrons are emitted. This phenomenon is referred to as secondary electron emission (SEE). The number of emitted secondary electrons per primary electron is the secondary electron yield (SEY), and the ratio of the number of secondary electrons to the number of primary electrons is the secondary electron emission coefficient.

In this disclosure, mainly Si₂H₆ and H₂ are employed, but other materials can also be used, as discussed further below. Electron simulated desorption (ESD) of hydrogen is maximum at electron energies of 100-150 eV. This perfectly aligns with the dissociation cross section of Si₂H₆, since Si₂H₆ dissociates at energies 20-100 eV, while peak H₂ dissociation is at 16-25 eV. Most backscattered and secondary electrons from Si are produced by incident electrons at 100-600 eV. These electron energies overlap with peak of H₂ dissociation cross section at ~16-25 eV.

Another factor that significantly contributes to the electron enhanced processing is dissociative electron attachment (DEA) to the precursor or the reactive background gases. DEA is a well-studied phenomenon in low temperature H₂ plasma studies. The incident electron is trapped by the neutral molecule in a resonant state, this trapping increasing the electron residence time sufficiently to allow the relatively slow-moving nuclei to dissociate. Schematically the process may be written as a two-step process:

*e⁻ + H*_{2(*v,J*)→} *H*_{2 →} *H⁻ + H*

where v and J denote the vibrational and rotational quantum numbers of the target hydrogen molecule.

This disclosure delves into the transformative potential of EE-CVD, employing, e.g., Si₂H₆ as the silicon precursor and hydrogen (H₂) as the reactive background gas (RBG). This disclosure concerns the intricate interplay between electrons and surface chemistry. By unraveling a mechanism wherein electrons facilitate disilane adsorption through the electron simulated desorption (ESD) of surface hydrogen, this disclosure presents a novel avenue for achieving highly selective silicon deposition.

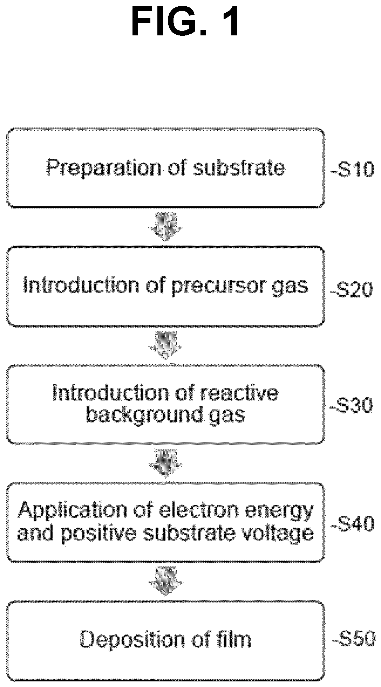

Thus, an embodiment of the present disclosure is as shown in the flowchart in FIG. 1 (the flowchart includes the optional introduction of the reactive background gas):
(1) Preparation of the substrate (Step S10): The substrate is typically a silicon wafer, which is cleaned and dried to ensure a smooth surface for deposition. However, the deposition in the present disclosure is not limited to being only on a substrate that is pure silicon. Rather, the EE-CVD technique applies to many substrates, including Si, dielectrics, metals, etc. One of the benefits of EE-CVD is to enable the growth of films on substrates on which films cannot be grown by conventional techniques.
(2) Introduction of the precursor gas (Step S20): The precursor gas used in EE-CVD is typically disilane (Si₂H₆), which is a hydride compound that contains silicon and hydrogen. However, the precursor gas is not limited to disilane and can be another silane, such as a trisilane, or it can be a different compound, such as a germanium compound like Ge₂H₆.
(3) Introduction of the reactive background gas (optional) (Step S30): The reactive background gas used in EE-CVD is typically hydrogen (H₂), which helps to enhance the dissociation of the precursor gas and create reactive species. However, the reactive background gas is not limited to hydrogen and can be a different reactive background gas, such as a doped reactive background gas.
(4) Application of electron energy and positive substrate voltage (Step S40): Electron energy is applied to the reaction chamber using a hollow cathode source, an electron gun or other device, which helps to enhance the dissociation of the precursor gas and create reactive species away from the electron source. A positive voltage is applied to the substrate to enhance the deposition by attracting negative ions to the substrate.
(5) Deposition of the film (Step S50): The reactive species react with the substrate to deposit a film, which can be composed of various materials such as silicon, silicon dioxide, or other compounds, such as compound semiconductors.

An aspect of the present disclosure lies in the eradication of nucleation delays during, e.g., silicon deposition on diverse substrates. The inherent tunability of electron parameters emerges as a powerful asset, providing precise control over deposition rates.

This disclosure not only concerns the capabilities of EE-CVD but underscores its potential to yield, e.g., high-quality, impurity-free silicon films. The versatility in tailoring deposition parameters positions EE-CVD as a formidable technique with broad applications in semiconductor device fabrication and materials engineering. As the intricate landscape of advanced electronic materials is navigated, EE-CVD stands at the forefront, poised to make significant contributions to progress in microelectronics and nanotechnology.

Thus, the present disclosure is directed to electron-enhanced processes for electron-enhanced chemical vapor deposition (EE-CVD). In EE-CVD, electrons are used together with, e.g., Si₂H₆ (disilane) as the Si precursor and H₂ (hydrogen) as the reactive background gas (RBG). Si₂H₆ can be pulsed while H₂ RBG and electrons remain continuously present in the chamber. The primary electron beam induces the simulated desorption of surface hydrogen and facilitates Si₂H₆ adsorption. Secondary electrons are emitted from the surface as a result of the primary electron beam energy at ~100 eV. The secondary electrons have much lower energies with a peak in their distribution around 2-4 eV. These secondary electrons can dissociatively attach to H₂ and Si₂H₆ and undergo dissociative electron attachment. This process yields H⁻ + H from H₂⁻ or SiH₃⁻ + SiH₃ from Si₂H₆⁻. By applying a positive voltage to the sample stage, the negative ions (H⁻ or SiH₃⁻) are pulled to the sample stage. These negative ions dramatically increase the EE-CVD.

An aspect of the present disclosure is the ability to deposit Si EE-CVD films at room temperature (e.g., about 15°C to about 28°C, or more particularly, 15°C to 28°C). In addition, the Si EE-CVD occurs without any nucleation delay. The mechanism of Si EE-CVD is also an aspect of this disclosure. Si EE-CVD is strongly enhanced by a positive substrate voltage. For example, a positive sample stage voltage range could be up to 100 V, or it could be 10-90 V. The following mechanism can explain the results: (1) The primary electrons at ~100 eV can generate secondary electrons from the substrate. (2) The lower energy secondary electrons can attach to the H₂ and/or Si₂H₆ reactive background gases in the reactor. (3) The electron attachment then dissociates the reactive background gas through dissociative electron attachment ionization. (4) The negative ions are attracted to the sample by the positive sample stage voltage. (5) The incoming negative ion flux leads to an enhancement in the deposition rates.

An advantage of the present disclosure is that Si EE-CVD occurs at room temperature. This low temperature lowers the thermal budget of semiconductor processing. Si EE-CVD also proceeds with no nucleation delay depending on the substrate. Analytical analysis of the Si EE-CVD films shows ultra-high quality, pure amorphous Si films with some hydrogen content.

Thus, Si EE-CVD can deposit silicon at room temperature. This low temperature growth provides many advantages compared with other methods for semiconductor processing. The low temperature deposition of silicon can be used during device processing.

This disclosure presents an innovative approach to electron-enhanced chemical vapor deposition (EE-CVD) using, e.g., disilane (Si₂H₆) as the silicon precursor and H₂ as the reactive background gas (RBG). An innovative advancement lies in the electron-mediated processes that facilitate the adsorption of Si₂H₆ through electron-simulated desorption (ESD) of surface hydrogen. The EE-CVD process was systematically investigated on various substrates, demonstrating a remarkable absence of nucleation delay during silicon deposition. A notable feature of this methodology is the ease of tuning electron parameters, enabling precise control over deposition rates. The deposited films exhibit high quality and are impurity-free, underscoring the potential of this technique for the fabrication of advanced semiconductor devices. The versatility of the electron-enhanced approach offers promising avenues for tailoring material properties in a controlled manner, opening new possibilities for applications in microelectronics and nanotechnology.

The Si hydride precursors in the present disclosure can be a silane, such as the aforementioned disilane, silane, trisilane, or dichlorosilane.

Moreover, the present disclosure also extends to the deposition of Ge using, e.g., GeH₄ or Ge₂H₆. Another Ge hydride precursor may be GeH₂Cl₂. Likewise, the EE-CVD process can be used for the deposition of any element that has a hydride precursor. The deposition of compound semiconductors is possible using two hydride precursors corresponding to the two elements in the compound semiconductor.

As a general matter, hydride precursors that can be used in the process of the present disclosure include Group IV hydrides, hydrides of Groups III and V, and hydrides of Groups II and VI. Examples of hydride precursors for single semiconductors are Si and Ge. Examples of hydride precursors for compound semiconductors include hydrides of Groups III and V such as Ga and As (forming a GaAs compound semiconductor), In and P (forming an InP compound semiconductor), and Ga and N (forming a GaN compound semiconductor), hydrides of Groups II and VI such as Zn and S (forming a ZnS compound semiconductor) and Zn and Se (forming a ZnSe compound semiconductor), and hydrides of Group IV and Group IV, such as Si and C (forming a SiC compound semiconductor) and Si and Ge (forming a SiGe compound semiconductor).

The reactive background gas is optional and can be H₂. The reactive background gas can be a doped reactive background gas, such as a reactive background gas doped with boron.

The film which is produced by the process of the present disclosure may be a silicon film, a germanium film, a silicon germanium film, or another elemental or compound semiconductor film.

Thus, as indicated above, EE-CVD uses electrons to enable the deposition of films on a substrate. The process involves the use of a hydride precursor, such as disilane (Si₂H₆), and optionally a reactive background gas, such as hydrogen (H₂), to deposit a film on a substrate. No direct plasma is used, i.e., the precursors are not introduced into regions where the (remote) plasma is. The remote plasma is used to generate the electrons (e.g., in the hollow cathode source). The electrons are very low energy (~100eV) and are used to dissociate the precursor molecules and create reactive species that can react with the substrate to form a film. Electrons with too low energy or too high energy will not lead to deposition. Deposition conditions are very mild (~room temperature), without heating, direct plasma, or other activation methods. The film is smooth, and there is no substrate damage.

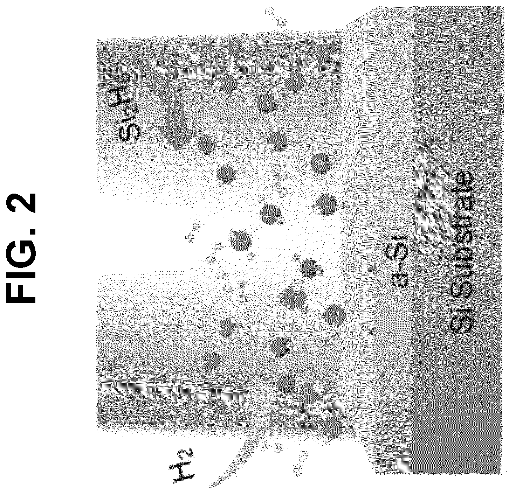

A diagram of one embodiment of the presently disclosed electron-enhanced chemical vapor deposition process is shown in FIG. 2. Deposition reactions are activated by electron flux reacting with molecules at low temperature, with no direct plasma. Halogen species are not required. The process is BEOL compatible and has been demonstrated at 25°C. It may provide an alternative to epitaxy. Also, it does not require a specific substrate. In addition, there are no nucleation delays in the process, and growth occurs immediately on all substrates. This is in contrast to existing technology in which (1) deposition reactions are activated by direct plasma (radicals, ions) or high temperature (>500°C), (2) halogen species may be required, (3) the process is not BEOL compatible, (4) an epitaxial process is slow and expensive, (5) a specific substrate (e.g., Si) is required, and (6) nucleation delay may occur on some substrates.

As discussed further below, deposition of amorphous Si films has been demonstrated at low temperature. The deposition is anisotropic using a (large opening) shadow mask.

### EXAMPLES

Further details and embodiments of the present disclosure will now be explained by way of the following examples of electron enhanced-chemical vapor deposition, which do not limit the present disclosure in any way.

### A. Reaction Chamber and Sample Preparation

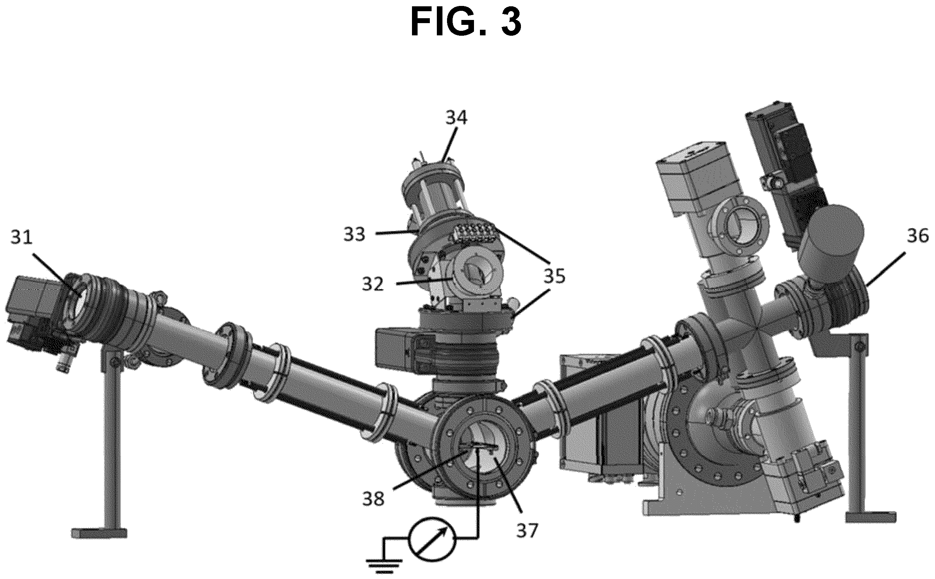

All experiments were conducted within a specialized V-shaped reactor featuring an in-situ (M-2000^{®}) spectroscopic ellipsometer (J.A. Woollam Co., Inc.), set at an incident angle of 70 degrees. This in-situ ellipsometer was used to monitor the growth of Si EE-CVD films. A schematic of the V-shaped reactor is provided in FIG. 3, in which the reactor includes iSE source 31, steering coil 32, bias grid 33, hollow cathode 34, collimating coils 35, iSE detector 36, reaction chamber 37, and floating sample stage 38. Details of M2000^{®} ellipsometer operation for electron enhanced thin film processes can be found in Collings, M. A.; Junige, M.; Cavanagh, A. S.; Wang, V.; Kummel, A. C.; George, S. M. Electron-Enhanced Atomic Layer Deposition of Ru Thin Films Using Ru(DMBD)(CO)3 and Effect of Forming Gas Anneal. J. Vac. Sci. Technol. A 2023, 41 (6), 062408.

An integral component of the reactor is a hollow cathode plasma electron source (HC-PES), designed to provide the electron beam to the surface. The HC-PES includes a molybdenum (Mo) aperture, approximately 2 mm in diameter, serving as an exit point for electrons. Additionally, a bias grid is incorporated, applying a positive voltage relative to the hollow cathode walls.

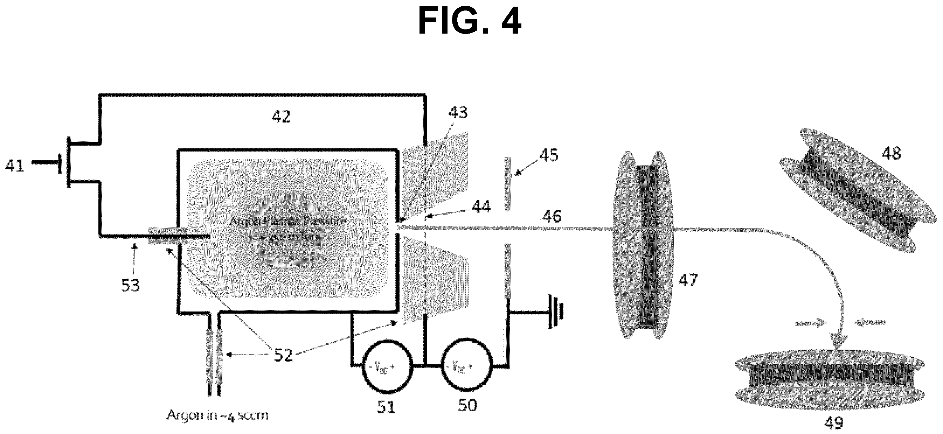

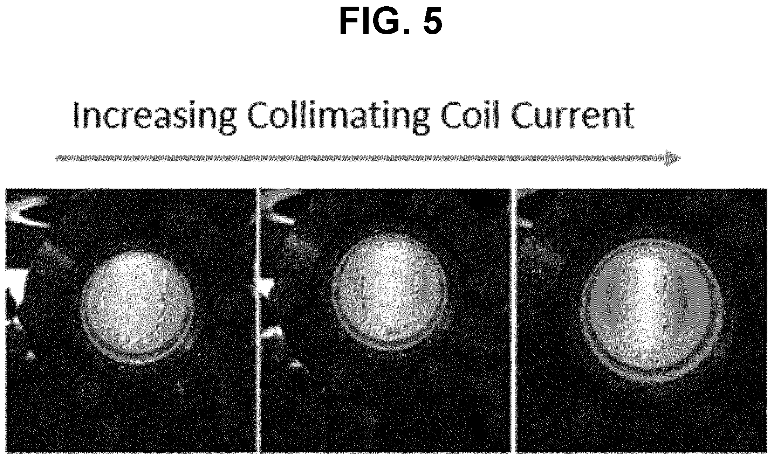

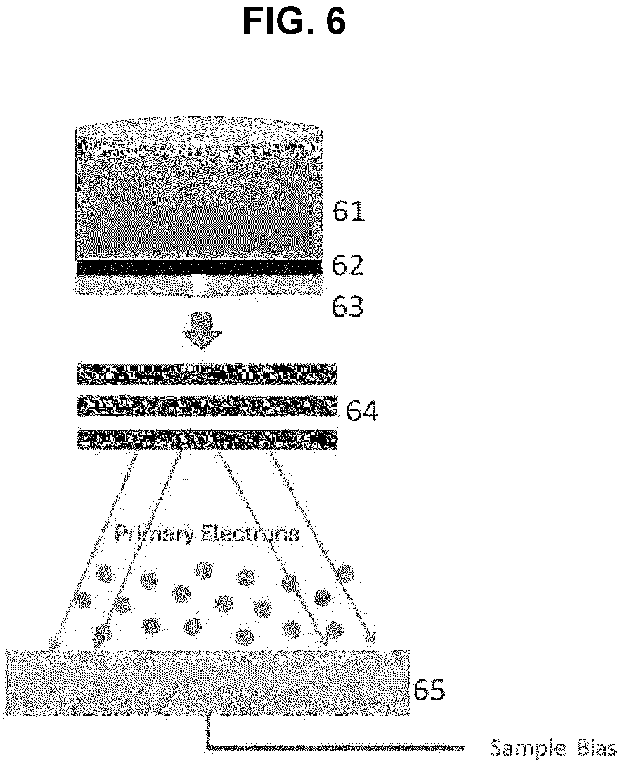

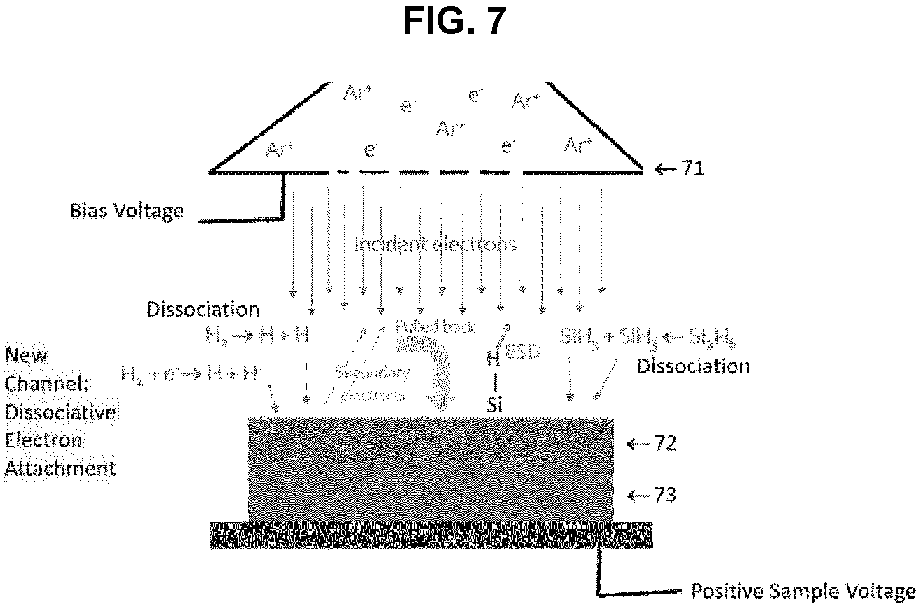

This setup enables electron emission from the HC-PES, subsequently accelerated and directed towards the sample surface through a series of electron optics, including steering and collimating coils. FIG. 4 shows a diagram of the hollow cathode operation, in which the diagram includes MOSFET 41, hollow cathode 42, aperture 43, bias grid 44, chamber ground 45, electron beam 46, collimating coil 47, steering coil 48, collimating coil 49, acceleration power supply 50, plasma power supply 51, dielectric 52 and secondary anode 53. FIG. 5 shows increasing collimating coil current, which is a parameter that can affect electron enhanced processes. Other parameters which can affect electron enhanced processes include steering coil current, bias grid voltage and electron energy, Si₂H₆ pressure, H₂ reactive background gas pressure, and secondary electron yield. FIG. 6 is a schematic diagram showing the hollow cathode generating primary electrons in an embodiment of the present disclosure, in which the diagram includes hollow cathode 61, bias grid 62, Mo aperture 63, electron optics 64, and substrate 65. FIG. 7 shows various pathways for electron-enhanced processing in an embodiment of the present disclosure, in which the figure includes bias grid 71, Si layer 72, and SiOz layer 73. In FIG. 7, bias voltage defines energy of electrons coming from HC-PES; sample voltage adds extra electron energy and collects secondary electrons emitted as a result of incident electrons; H₂ and electrons are present at all times, and Si₂H₆ is pulsed into reactor; electrons dissociate H₂ and Si₂H₆, and electron stimulated desorption (ESD) of H from the surface occurs; and secondary electrons may attach to H₂ and dissociate H₂ according to H₂ + e⁻ → H + H⁻, with sample voltage pulling H⁻ to the surface for reaction. Comprehensive details regarding the reactor design and operation can be found in Gertsch, J. C.; Sobell, Z. C.; Cavanagh, A. S.; Simka, H.; George, S. M. Electron-Enhanced SiO2 Atomic Layer Deposition at 35 °C Using Disilane and Ozone or Water as Reactants. J. Vac. Sci. Technol. A 2023, 41 (4), 042404 and Collings et al. set forth above. Electrons were generated utilizing an argon (Ar) plasma within the HC-PES, sourced from Airgas with 99.999% purity. Ar flow through the hollow cathode cavity was 3 sccm controlled by a mass flow controller (MFC) (e.g., MKS, 14 sccm range). A bias grid maintained at a voltage of -50 V was employed to regulate the energy of electrons emitted from the HC plasma.

The incident electron current on the substrate and sample holder was approximately 200 mA. To make the accurate current measurements, while taking into account the secondary electrons and negative ions (as a result of DEA), a positive sample bias of + 90 V was applied on the stage. Sample current was measured by a multimeter (Keithley, DMM7510 7.5 Digit Multimeter) probe affixed to the sample stage.

Si EE-CVD experiments were done on a Si (100) on insulator (SOI). This SOI substrate has a device thickness of 700 A, with a box layer thickness of 20000 A. Thermal SiO₂ with an oxide thickness of ~5000 A was also used as an insulating substrate. Experiments were also conducted on a stoichometric SiN surface, with a thickness of 1000 A and an intrinsic oxide layer of ~13 A. Si EE-CVD process consists of Si₂H₆ pulses every 0.5 s, with a purge time of 10 s in between, while H₂ and electrons continuously remains in the chamber. All experiments were performed at room temperature.

### B. Precursors and Reactants

During Si EE-CVD experiments, electrons were supplied continuously, and the reactor had a constant flow of 3 sccm hydrogen (H₂, 99.999, Airgas) controlled by an MFC (MKS, 50 sccm range). The pressure in the chamber with only H₂ flowing was <3 mTorr. Disilane (Si₂H₆, 99.998%, Voltaix) at room temperature was used as the Si precursor. Si₂H₆ was pulsed into the chamber. Chamber pressure increased to 20 mTorr during the Si₂H₆ pulses. Prior to the experiments, all substrates were pre-cleaned by rinsing with acetone, isopropyl alcohol (IPA) and water, in the same order and dried with N₂.

### C. Analysis

Films were characterized using various analytical tools. Ex situ X-ray photoelectron spectroscopy (XPS, PHI 5600) depth profiling was used to measure composition of the Si EE-CVD films. Elastic Recoil Detection Analysis (ERDA) was also done to detect the amount of hydrogen present in the films. Roughness and film density were measured using x-ray reflectivity (GIXRD, Bede D1 X-ray diffractometer, Bruker) and atomic forced microscopy (AFM, NX10, Park Systems) for Si EECVD films. A laser microscope was used as an optical surface profilometer to see the surface topography and step height of the patterns made using stainless steel mesh.

### D. Results and Discussion

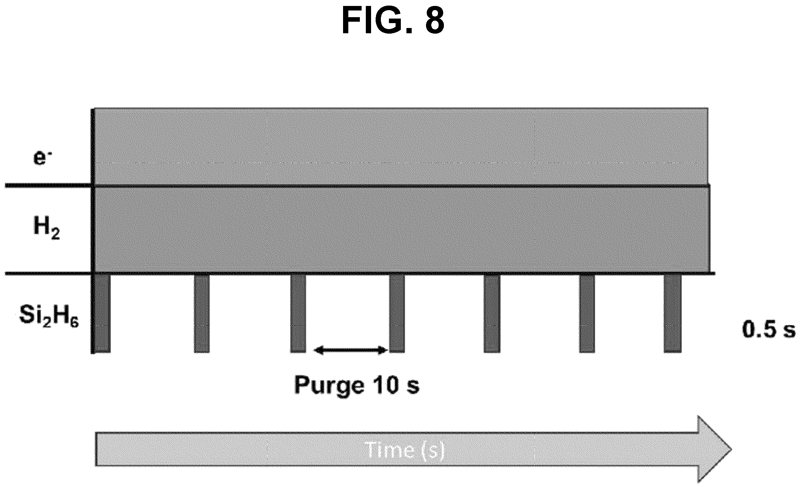

FIG. 8 illustrates the schematic diagram depicting the Silicon (Si) EE-CVD process. In this process, electrons and H₂ are continuously present within the chamber, while Si₂H₆ is introduced at regular intervals of 0.5 seconds. The Si EE-CVD procedure was conducted across various substrates. Based on the schematic in FIG. 8, Si EE-CVD was carried out. There are two settings at which Si EE-CVD was done, with and without a presence of positive sample bias on the sample stage.

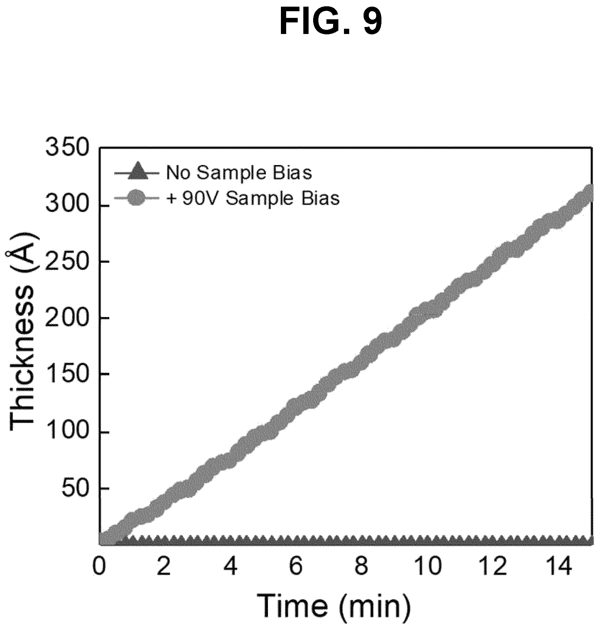

FIG. 9 shows the Si EE-CVD growth on SOI (Si on insulator), in the presence and absence of the positive sample bias. The growth rate of Si EE-CVD without sample bias is negligible with the measured sample current hovering around ~10 mA. However, upon application of the +90 V sample bias, the growth rate experiences a substantial surge to ~20 A/min. Moreover, the Si EE-CVD growth exhibits a highly linear trend under the influence of sample bias. These results underscore the critical role of secondary electrons in the surface reaction kinetics, particularly their involvement in processes such as DEA to H₂ reactive background gas (RBG) molecules and Si₂H₆ Si precursor molecules.

According to existing literature, the DEA to Si₂H₆ yields two distinct groups of negative ion fragments. One group comprises SiH₃⁻, SiH₂⁻, SiH⁻, and Si⁻ ions, while the other group includes Si₂H₅⁻, Si₂H₄⁻, Si₂H₃⁻, Si₂H₂⁻, Si₂H⁻, and Si₂⁻ ions. The dissociate electron attachment of H₂ and Si₂H₆ is shown in the equation below (Eqn. 1):

*H*₂ *+ e⁻ = H + H⁻*

*Si*₂*H*₆ + *e⁻* = - - - - - (monosilane and disilane fragments)

These chemical reactions highlight the intricate processes occurring at the surface interface during Si EE-CVD, further emphasizing the indispensable role of secondary electrons in mediating these reactions and influencing the growth kinetics.

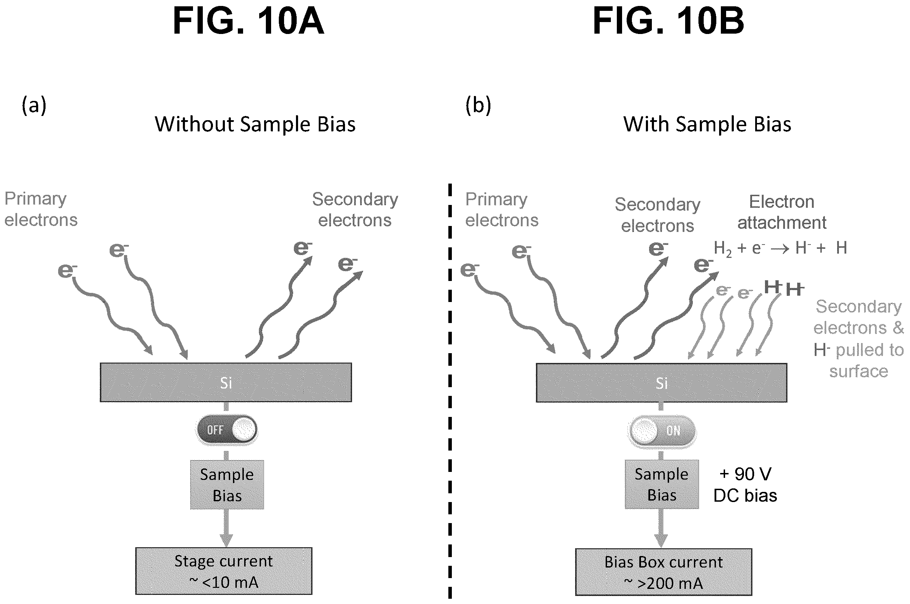

FIGS. 10A and 10B depict the schematic diagrams illustrating the experimental setups utilized in Si EE-CVD with and without sample bias, respectively. Throughout the experimental investigations, the pivotal role of secondary electrons and DEA to H₂ and Si₂H₆ molecules was elucidated. Consequently, capturing all secondary electrons, as well as the negative ions (H⁻ and SiH₄⁻ ions), is necessary to accurately measure the sample current.

In FIG. 10A, the setup is presented without accounting for secondary electrons. In this case, there is no sample bias applied to the sample surface. A primary electron beam is directed towards the sample, resulting in the emission of secondary electrons from the substrate. However, owing to the absence of a positive sample bias on the sample surface, no secondary electrons are collected or drawn back to the surface. With an energy level typically ranging from 3 to 4 electron volts (eV), these emitted secondary electrons disperse towards ground through the chamber walls. Notably, the measured sample current registers at approximately ~10 mA in the absence of positive sample bias.

Conversely, in FIG. 10B, upon application of a positive sample bias of + 90 V, the sample current surges to over 200 mA. This substantial increase in current can be attributed to the attraction of secondary electrons back to the surface, facilitated by the positive sample bias. Furthermore, some secondary electrons engage with the H₂ reactive background gas (RBG) as well as Si₂H₆ molecules, leading to DEA, as illustrated in Eqn. 1. Consequently, this process results in the retrieval of secondary electrons and negative ions to the surface. These entities actively participate in the surface reaction kinetics, thereby influencing the overall deposition mechanisms.

The present disclosure differentiates over other processes in that, e.g., the positive sample bias pulls secondary electrons back to the surface and leads to more reactions, thereby resulting in faster deposition.

The Si EE-CVD film deposited with positive sample bias was characterized and compared using various techniques, including in-situ ellipsometry and X-ray Reflectivity (XRR). The comparisons focus on film thickness, density, and roughness. The quantitative outcomes are summarized in Table 1 below:

**Table 1**

| No. of cycle | Thickness (nm) (Ellipso) | Thickness (nm) (XRR) | Roughness (Å) (XRR) | Density (g/cm³) (XRR) |
|---|---|---|---|---|
| 0 | 1.1 | 0.101 | 4.57 | 2.43 |
| 50 | 13.18 | 11.3 | 5.4 | 1.88 |
| 100 | 23.10 | 25 | 6.75 | 2.25 |
| 200 | 49.05 | 47.31 | 8 | 2.10 |

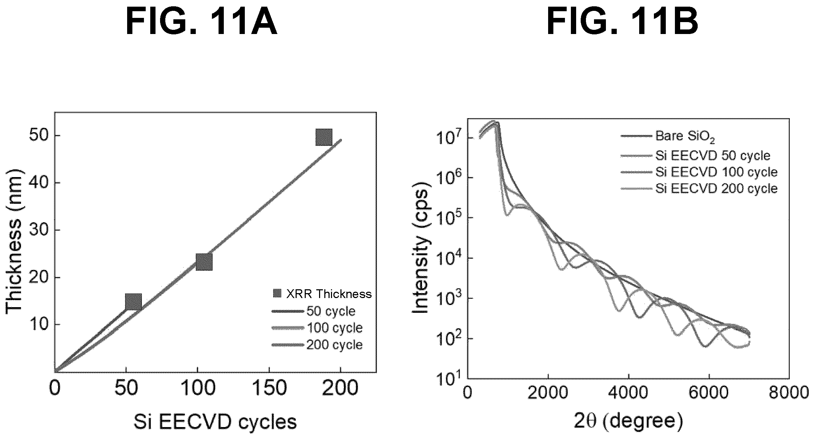

FIGS. 11A and 11B illustrate the in-situ ellipsometry thickness for Si EE-CVD film and the XRR of the Si EE-CVD film, respectively.

FIG. 11A depicts the Si EE-CVD film thickness as a function of the number of cycles. A noticeable increase in thickness is observed, with measurements of 13 nm, 25 nm, and 50 nm for 50, 100, and 150 Si EE-CVD cycles, respectively. The films grow continuously, without any nucleation delay, and the growth is linear.

FIG. 11B presents the X-ray reflectivity curves for the bare Si and the Si EE-CVD films with thicknesses of 13 nm, 25 nm, and 50 nm, respectively. The results indicate that the amplitude of the oscillations increases with the thickness, due to the increased roughness as the film grows thicker. As summarized in Table 1, the roughness of the Si EE-CVD films increases as a function of the square root of film thickness. With the increase in film roughness, the reflected X-rays decrease more rapidly, leading to a faster decay rate of X-ray reflectivity for films with larger roughness.

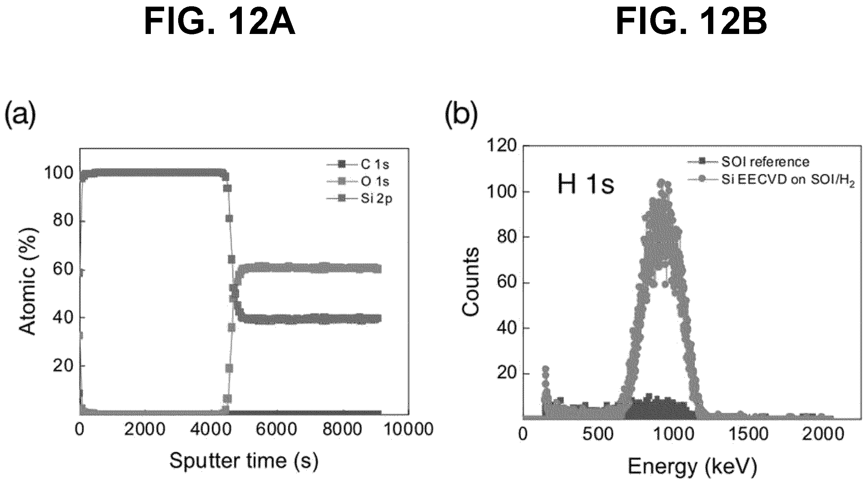

The investigation of Si EE-CVD films was further extended through a comprehensive analysis of ~100 nm Si EE-CVD films using X-ray Photoelectron Spectroscopy (XPS) for chemical composition and Elastic Recoil Detection Analysis (ERDA) to quantify the presence of hydrogen (H) within the film, as depicted in FIGS. 12A and 12B, respectively.

In FIG. 12A, the XPS depth profile demonstrates a significant presence of Si 2p at 100 atomic percent (100 at. %), while O 1s remains negligible at 0 at. %, and the C 1s peak also remains at 0 at. %. However, after 4000 s of sputter time, the O 1s peak saturates at 60 atomic percent, while Si 2p saturates at 40 atomic percent, indicating the presence of an underlying thermal oxide layer.

FIG. 12B exhibits the H 1s peak from ERDA, providing insight into the concentration of hydrogen in the films. A notable H 1s peak is observed for the Si EE-CVD film, contrasting with the absence of such a peak in the reference sample. The hydrogen concentration was calculated to be 9 at. %, with H₂ molecules per unit volume of 9×10⁷ H/cm³. These results indicate that Si EE-CVD films have a small but measurable H concentration in the films.

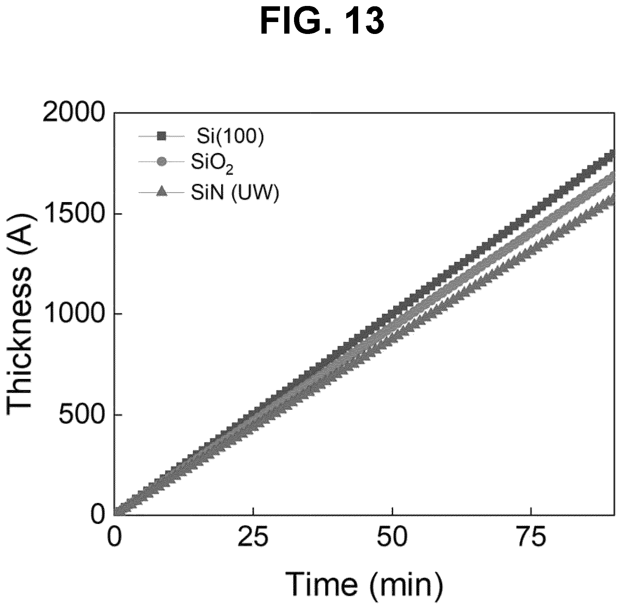

The process was further investigated by growing Si EE-CVD films on various substrates. FIG. 13 represents a graphical representation of Si EE-CVD thickness over time on Si (100), thermal SiO₂, and Si₃N₄ substrates. Notably, Si EE-CVD film deposition occurs promptly on all substrates without any discernible nucleation delay. This emphasized that EE-CVD grown Si films can grow on any substrate independent of whether the substrate is insulating, conducting or any other. Electron simulated growth does not have any preferential growth dependence with respect to the substrate. This makes the electron enhanced process much more promising than the existing process.

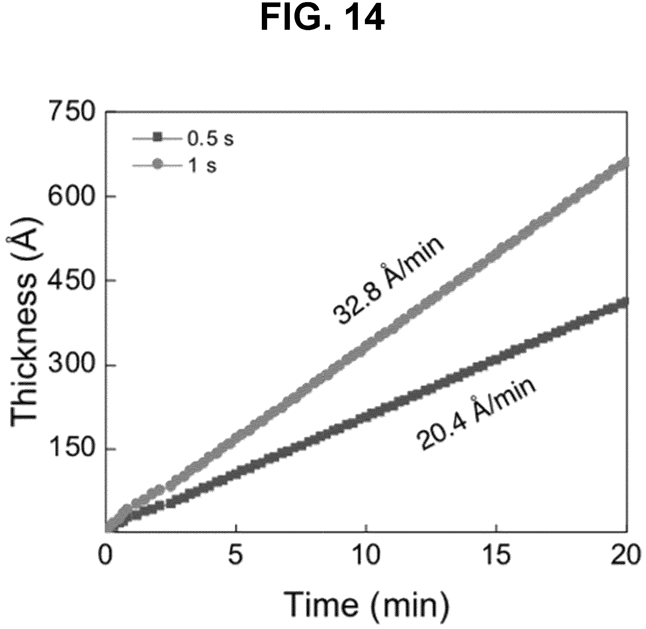

The influence of Si₂H₆ dose time on film growth was further scrutinized, as depicted in FIG. 14, which illustrates the relationship between thickness and time. Si EE-CVD experiments were conducted with dose times of both 0.5 seconds and 1 second. Notably, the results reveal a linear growth trend for both dose times, indicating a consistent and controlled deposition process. Moreover, the growth rate demonstrates a notable increase with an extension in dose time. Specifically, for a Si₂H₆ dose time of 0.5 s, the growth rate is measured at approximately ~20 A/min. Conversely, when the dose time is extended to 1 second, the growth rate escalates to approximately ~32 A/min.

This observed augmentation in growth rate with prolonged dose time underscores the direct correlation between precursor dose duration and film growth kinetics. These findings elucidate the pivotal role of Si₂H₆ dose time in modulating the rate of Si EE-CVD film deposition. The linear growth behavior across different dose times signifies the robustness and reproducibility of the deposition process. Moreover, the ability to control growth rate by adjusting dose time offers valuable insights for optimizing Si EE-CVD parameters to tailor film characteristics for specific applications.

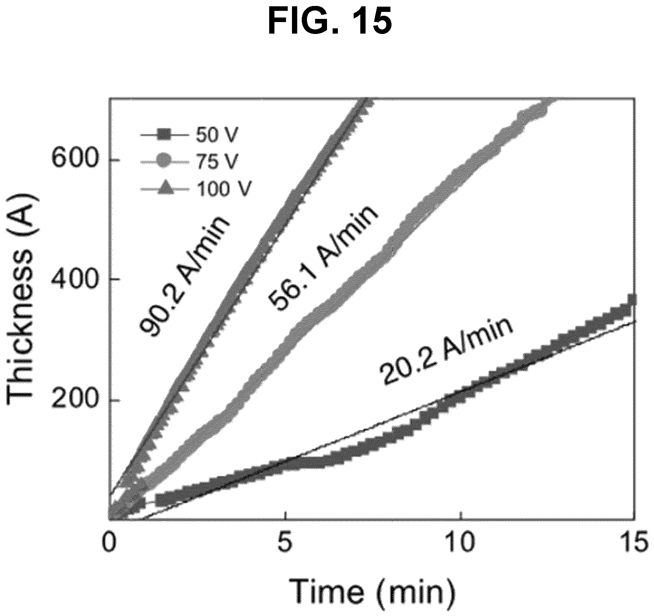

Further investigation into the Si EE-CVD process involved exploring additional parameters to fine-tune the deposition process. FIG. 15 presents the results of Si EE-CVD conducted at various bias grid voltages. The bias grid voltage was systematically increased from 50 V to 100 V and then to 150 V. Remarkably, as the bias grid voltage was elevated, the growth rate exhibited a corresponding increase, escalating from approximately ~20 A/min to 56 A/min, and ultimately reaching 90 A/min. The growth rate at all three bias grid voltages remained linear, indicative of a consistent and controlled deposition process across the voltage range explored. This linear growth behavior underscores the robustness and reliability of the Si EE-CVD process under varying bias grid voltages. These findings contribute valuable insights into optimizing the Si EE-CVD process by manipulating bias grid voltages, thereby expanding the toolkit for tailoring Si film properties to meet specific technological requirements.

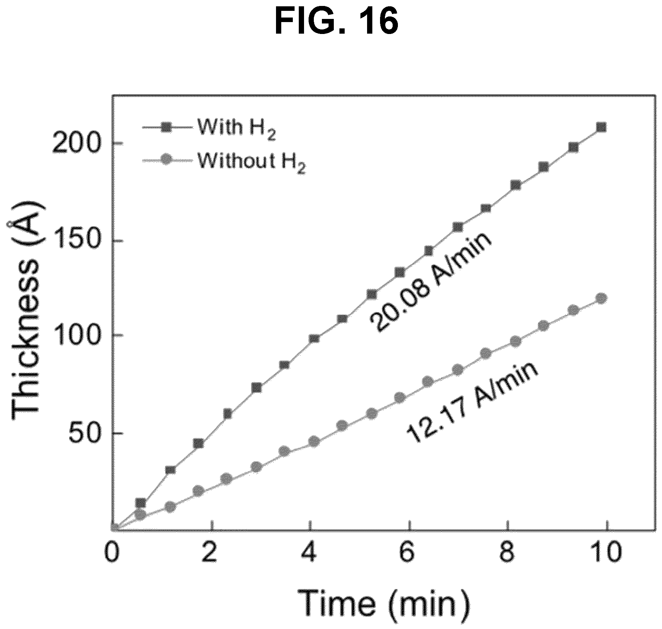

Further exploration of Si EE-CVD was conducted through experiments conducted with and without the presence of H₂ RBG, as illustrated in FIG. 16. Intriguingly, Si EE-CVD film formation occurs even in the absence of H₂ RBG, solely with the presence of Si₂H₆ precursor gas. The growth exhibited a linear trend, with a measured growth rate of approximately ~12.17 A/min. Conversely, in the presence of H₂ RBG, the growth rate experienced a significant elevation while maintaining a linear deposition pattern. The growth rate in the presence of H₂ RBG is ~20 A/min.

These findings suggest that Si EE-CVD film deposition can proceed efficiently solely with Si₂H₆ precursor gas, indicating its capability to serve as a viable source for Si film growth in the absence of H₂ RBG. Moreover, the presence of H₂ RBG enhances the growth rate further, underscoring its role in augmenting the deposition process. Notably, the deposition remains linear in both scenarios, indicative of a controlled and uniform growth mechanism. This comparative analysis highlights the versatility of Si EE-CVD and underscores the potential for tailoring growth conditions to achieve desired film characteristics. The observed growth behavior sheds light on the interplay between precursor gases and reactive background gases, offering insights into optimizing Si EE-CVD processes for various applications.

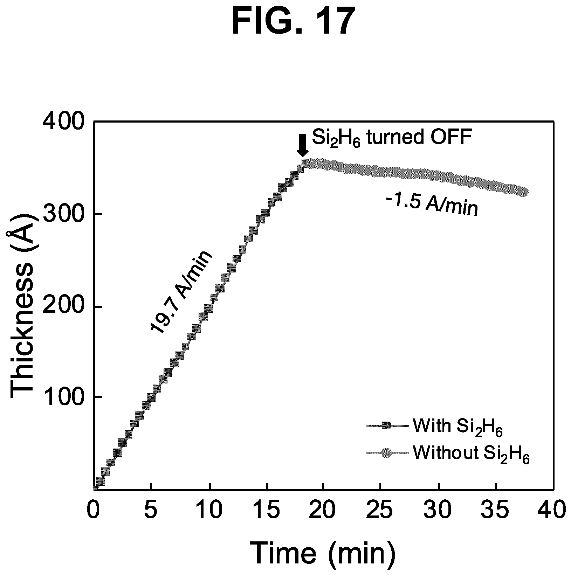

Further investigation of the Si EE-CVD film was conducted by comparing growth processes with and without the presence of Si₂H₆. The aim of conducting experiments without Si₂H₆, utilizing solely H₂ as a RBG along with electrons present in the chamber, was to comprehend the spontaneous etching phenomena occurring in the presence of H₂ and electrons. FIG. 17 shows the Si EE-CVD growth in the presence and absence of Si₂H₆. H₂ is used as a RBG in both cases, while electrons continuously present in the chamber.

In the presence of Si₂H₆, the film grows linearly with a growth rate of ~ 20 A/min, which is consistent with the earlier results. When Si₂H₆ is turned off, the film slowly starts to etch in the presence of H₂ RBG and electrons. This is very interesting observation, since H₂ seems to etch in the presence of electrons, at room temperature, with an etch rate of ~1.5 A/min.

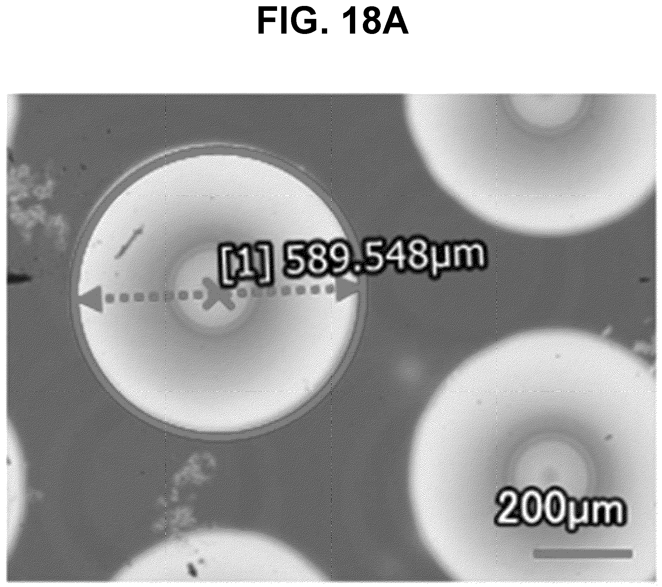

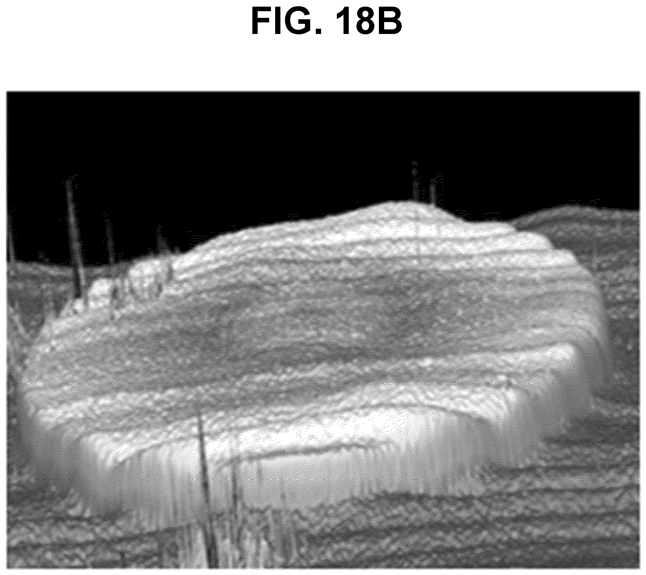

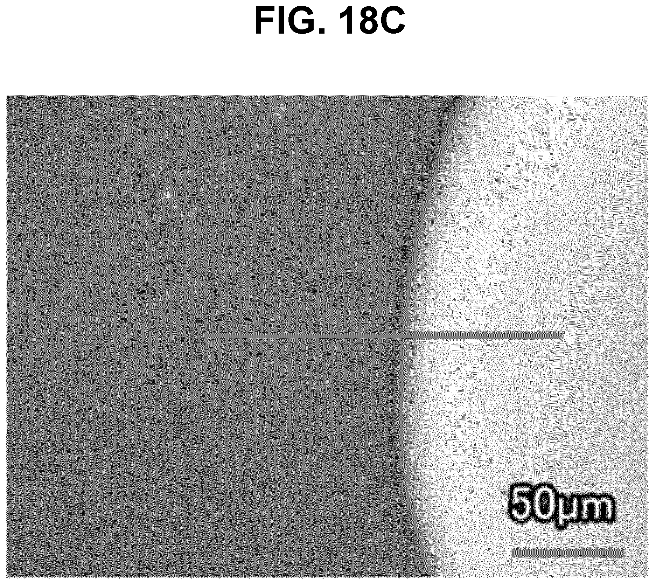

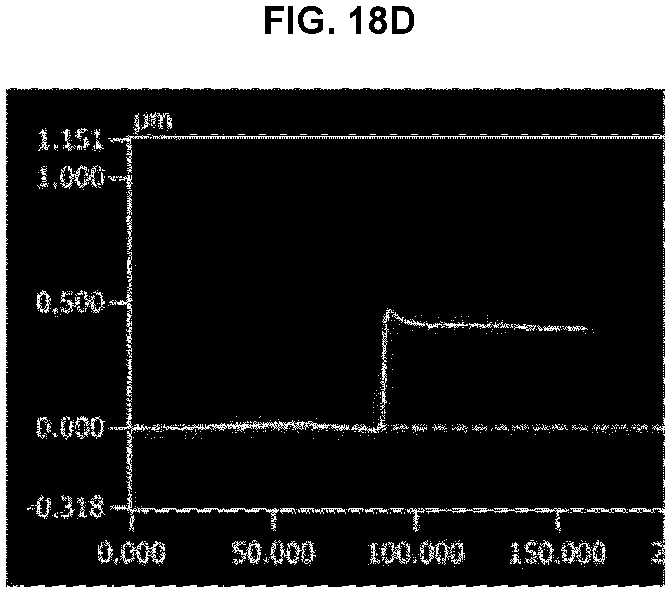

An attempt to observe the isotropic deposition of Si EE-CVD film was also made. In order to do that, a 3 mm thick stainless steel mesh was used, with circular pores of ~600 nm. After 200 cycles of Si EE-CVD process, circular mesa like patterns are observed. FIGS. 18A-18D show the surface profilometry analysis after the Si EE-CVD film deposition. FIG. 18A shows the surface topographical images of the patterns formed. As can be seen, the diameter of the mesa-like patterns is measured to be 590 um, which is very consistent with the size of the bare stainless-steel mesh openings. FIG. 18B shows the 3D image of the mesa-like pattern, which seems very homogenous. Step height of this mesa-like pattern was measured by choosing two points, one on the substrate surface and other on the mesa-like pattern, which shows the Si EE-CVD film deposition, as shown in FIG. 18C. The purpose of doing that was to measure the step height or thickness. As can be seen in FIG. 18D, the thickness of the mesa-like structure comes to ~480 nm.

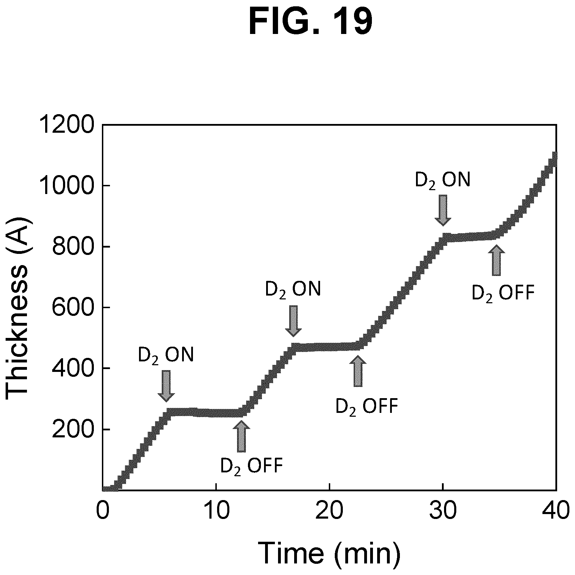

The Si EE-CVD process was further investigated by using D₂ instead of H₂ as a RBG. Given the similar chemical nature of D₂ and H₂, the aim was to determine if a Si EE-CVD film with higher purity and lower hydrogen content could be achieved using D₂. As shown in FIG. 19, the Si EE-CVD film grows linearly without any nucleation delay in the presence of just Si₂H₆ and electrons. However, when D₂ is introduced into the chamber, D₂ poisons the process, causing the film to stop growing. Periodically turning D₂ on and off revealed that the film resumes growth in the absence of D₂ and remains saturated when D₂ is present.

This behavior is attributed to the DEA cross-section differences between H₂ and D₂. For H₂, the peak cross-section energy is approximately 3.4 eV, whereas for D₂, the peak cross section energy is around 14 eV. This significant difference in peak cross-section energies means that D₂ does not effectively participate in the Si EE-CVD process.

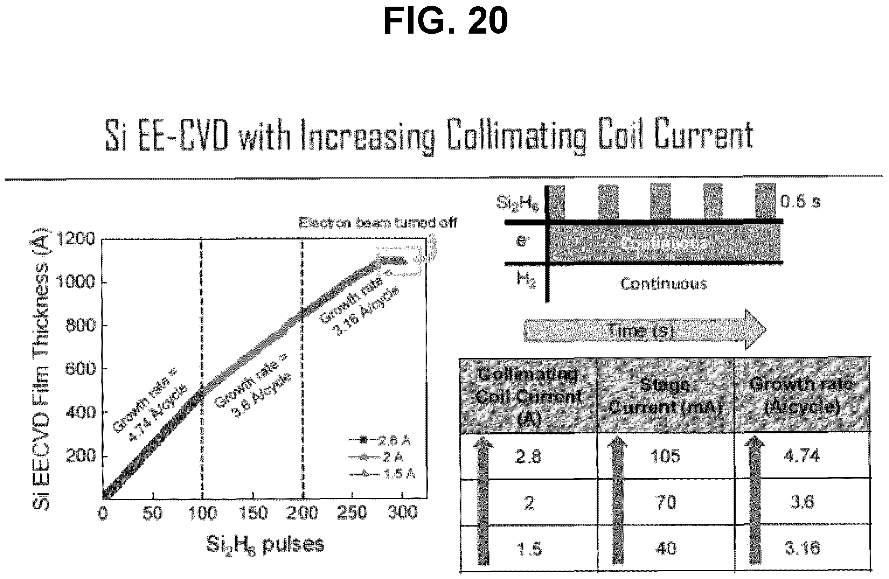

FIG. 20 shows an exemplary embodiment of the present disclosure for Si EE-CVD with increasing collimating coil current.

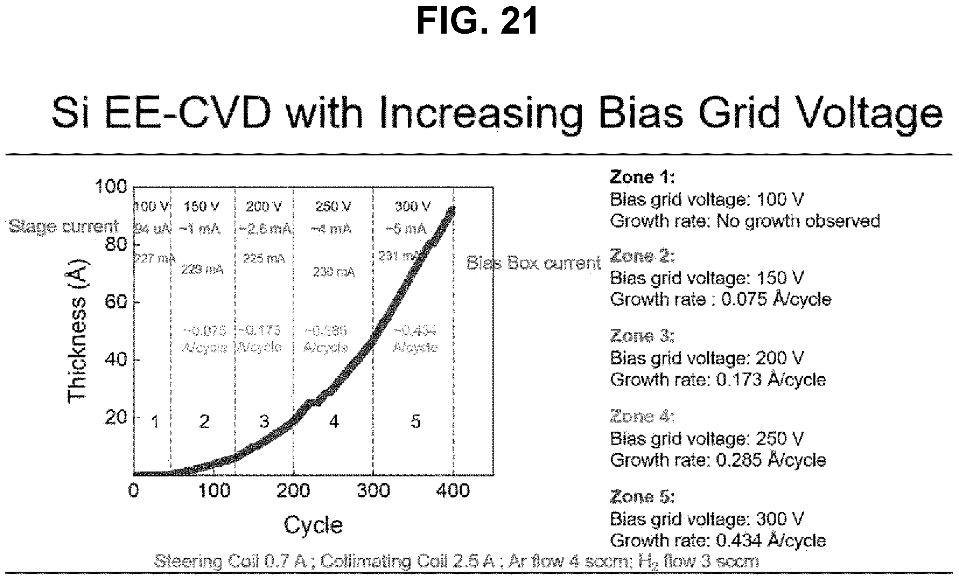

FIG. 21 shows an exemplary embodiment of the present disclosure for Si EE-CVD with increasing bias grid voltage.

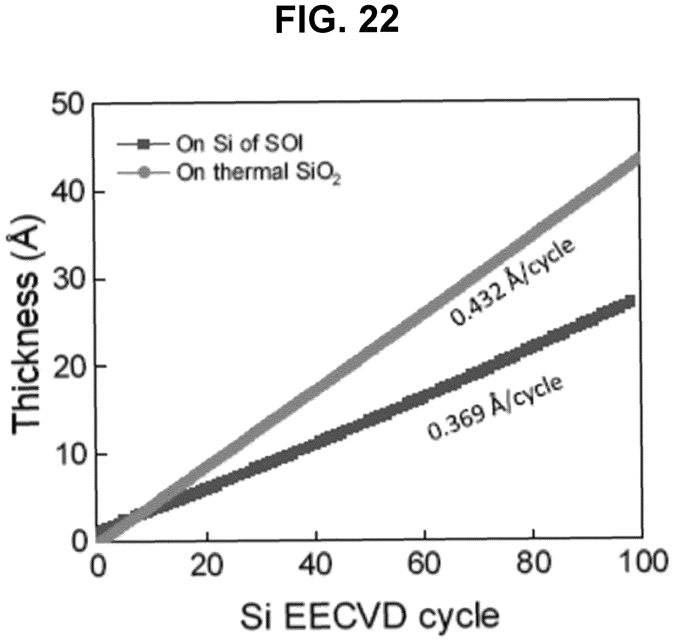

FIG. 22 shows a graph of film thickness vs. the number of Si EE-CVD cycles for an exemplary embodiment of the present disclosure and shows the advantages of Si EE-CVD film, including high quality films deposited at room temperature, the ability to deposit on different substrates without nucleation delay, and growth controllability by tuning different electron parameters.

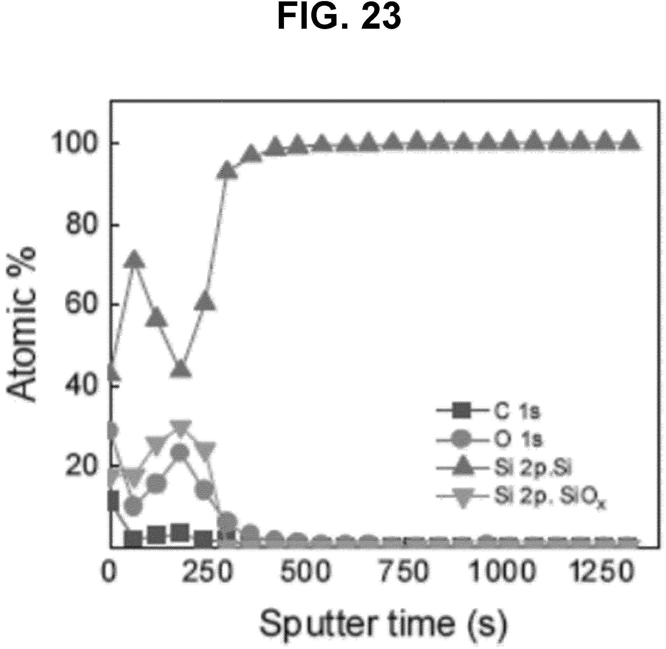

FIG. 23 shows the XPS depth profile of an exemplary embodiment of the present disclosure.

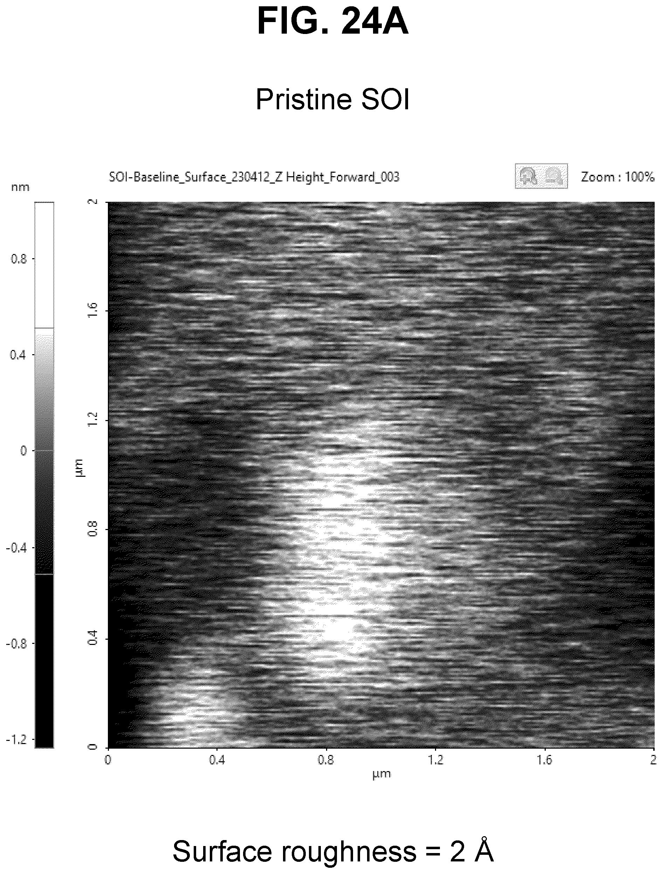

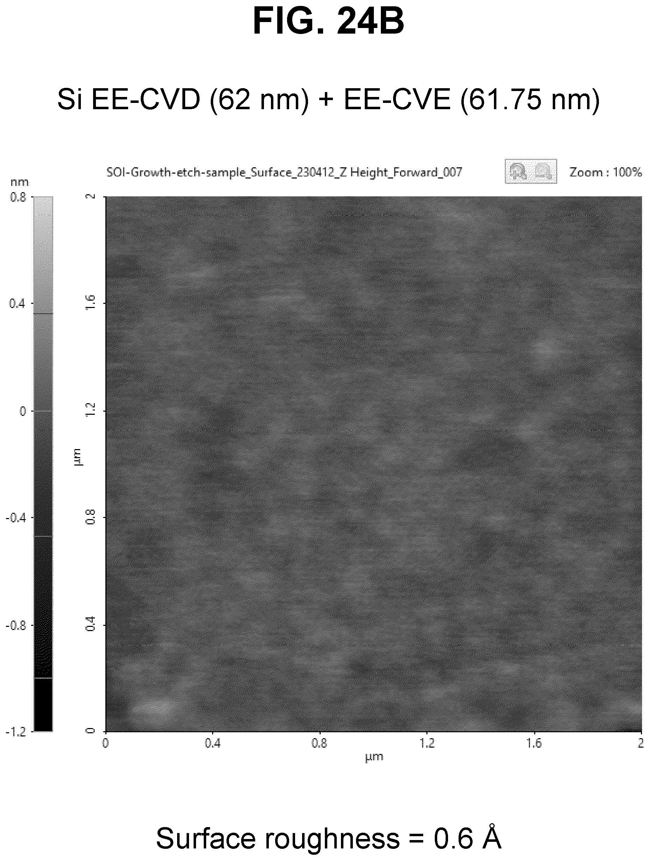

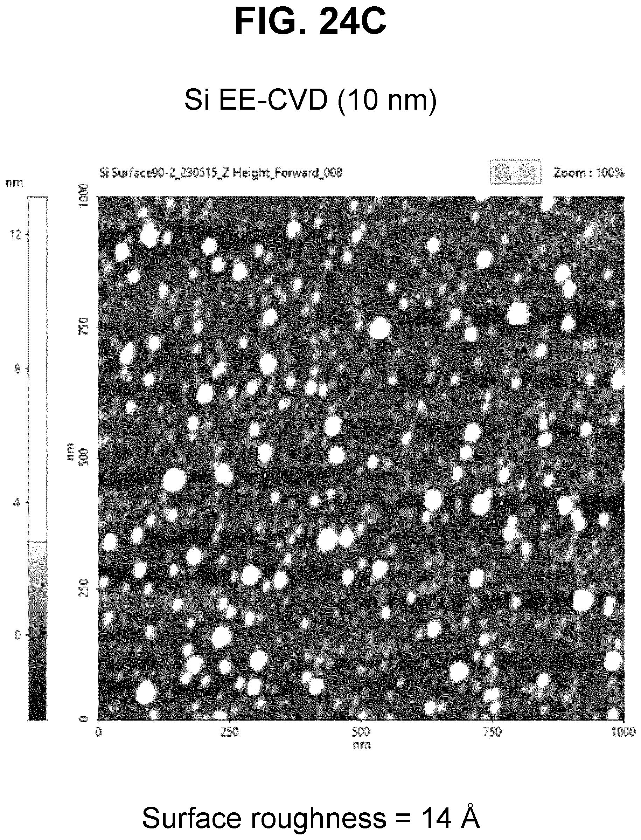

FIGS. 24A-24C show the surface roughness of various embodiments, including an exemplary embodiment of the present disclosure.

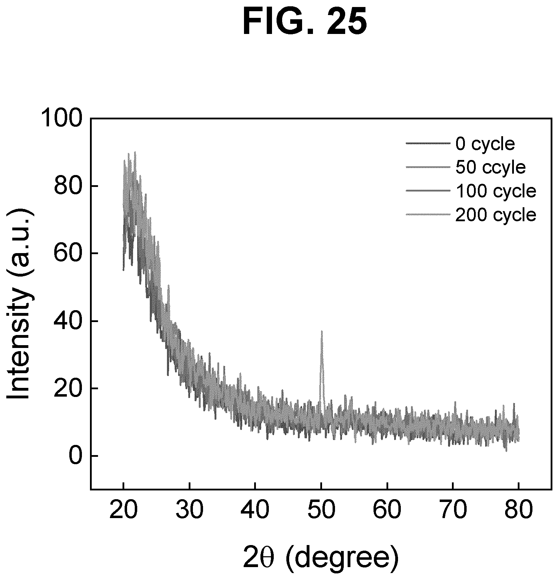

FIG. 25 shows an XRD 2*θ* scan of an exemplary embodiment of the present disclosure, in which Si EE-CVD films (10 nm) grown at room temperature are amorphous.

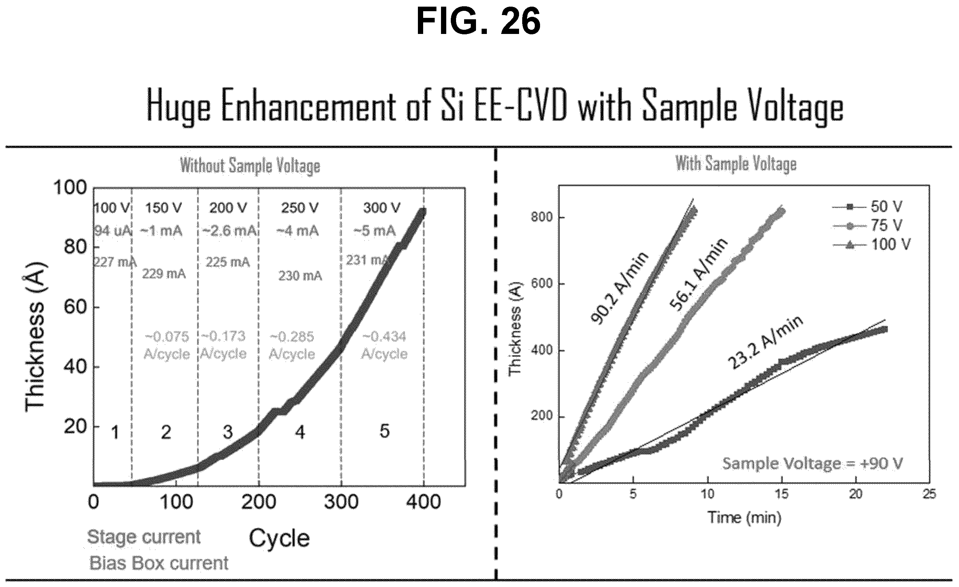

FIG. 26 shows the significant enhancement of Si EE-CVD with sample voltage for an exemplary embodiment of the present disclosure.

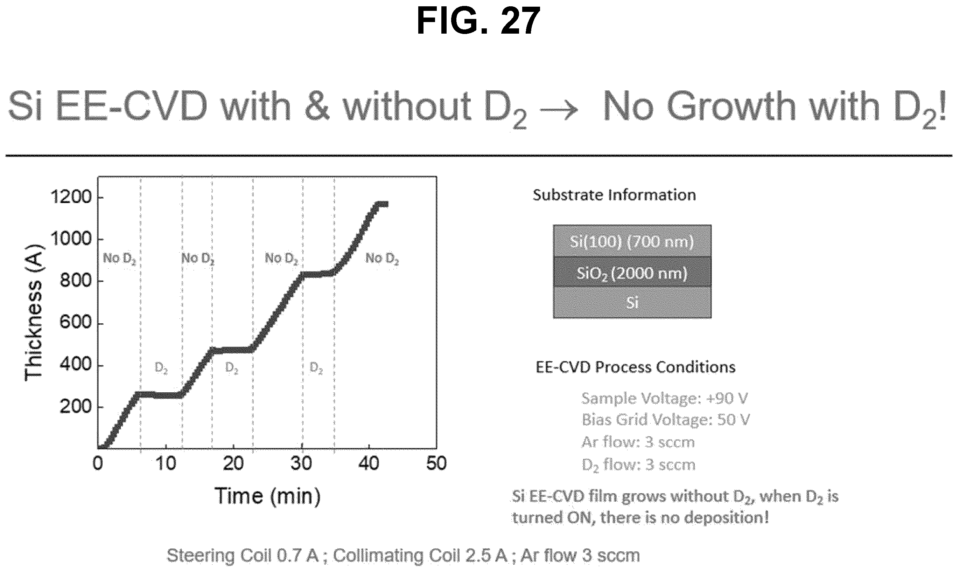

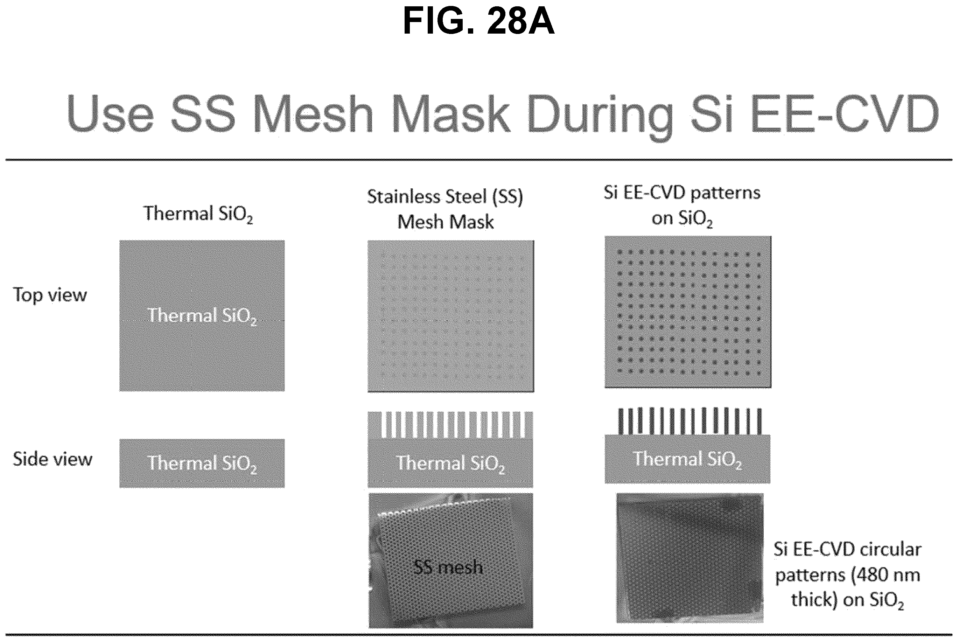

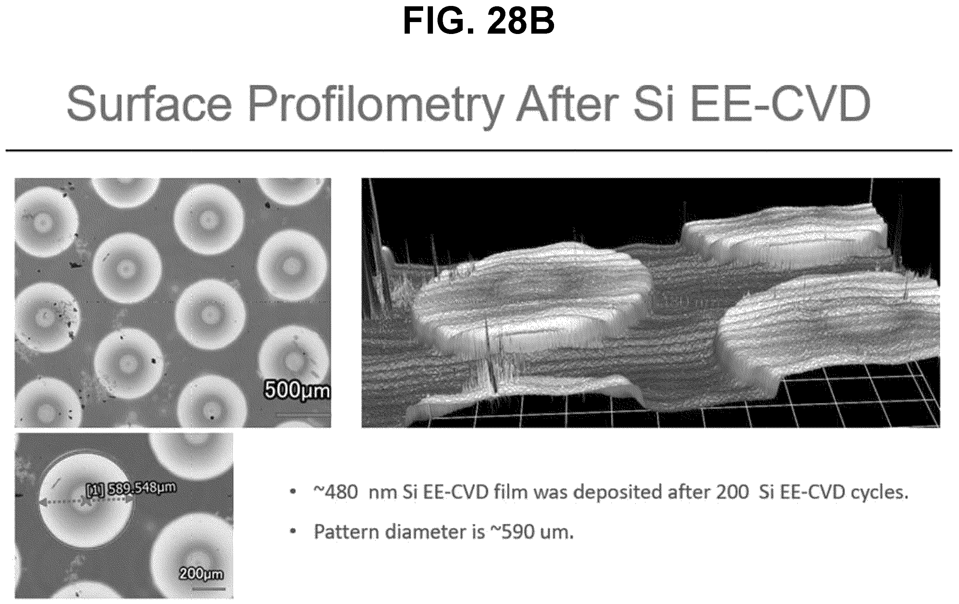

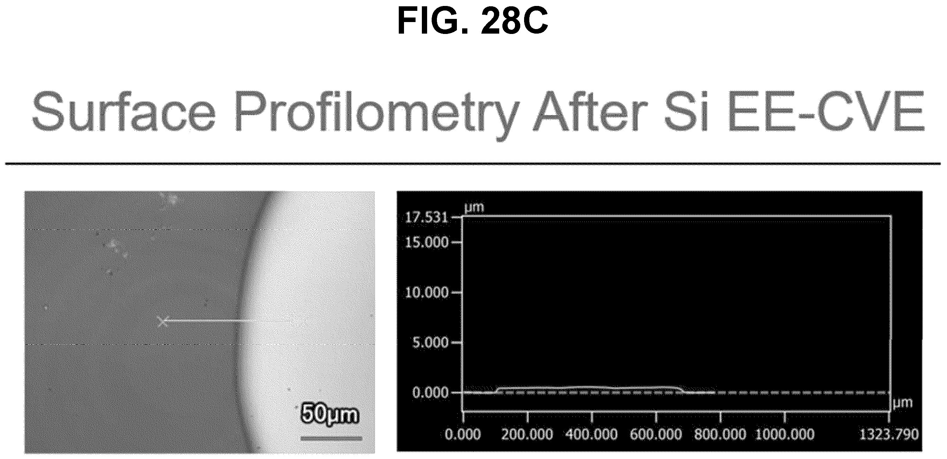

FIG. 27 shows Si EE-CVD with and without D₂ for an exemplary embodiment of the present disclosure. As can be seen from FIG. 28, EE-CVD is very controllable. It can be turned on / shut off by controlling the electron stream and also by changing the reactive background gas (e.g. D₂ vs. H₂), showing electrons are enablers and react with gas molecules.

FIGS. 28A-28C show the use of a stainless steel mesh mask during Si EE-CVD and the resulting surface profilometry after Si EE-CVD for an exemplary embodiment of the present disclosure. Anisotropic deposition was demonstrated on ~600 µm patterns, without any optimization.

### E. Conclusions

Si EE-CVD films were deposited using Si₂H₆, H₂ RBG and electrons. Electrons play a role in Si EE-CVD film growth. They facilitate Si₂H₆ adsorption due to electron simulated desorption of surface hydrogen. And the electrons also help dissociate Si₂H₆ and H₂ molecules. In addition, secondary electrons are emitted as a result of primary electron beam. These secondary electrons play a role in EE-CVD of Si, as they attach to Si₂H₆ and H₂ molecules due to a phenomenon called dissociative electron attachment. This further contributes to the Si EE-CVD growth.

In this disclosure, Si EE-CVD film was grown using EE-CVD and impact of secondary electrons, DEA, effect of sample bias, role of grid bias, H₂ flux and many other factors that affect the Si EECVD growth were investigated in detail. Si EECVD film was grown on various substrates, without any nucleation delay. Positive sample bias on the stage helps to collect secondary electrons, and growth rates are much higher. Si EECVD grown films were characterized using various techniques, and high quality, pure Si films were formed, with very little H₂ in the films.

The foregoing is illustrative of exemplary embodiments and is not to be construed as limiting the disclosure. Although a few exemplary embodiments have been described, those skilled in the art will readily appreciate that many modifications are possible in the above embodiments without materially departing from the disclosure.

## Claims

1. A method for electron-enhanced chemical vapor deposition of a film, comprising:
cleaning and drying (S10) a substrate (65),
introducing (S20) at least one hydride precursor gas into a reaction chamber containing the substrate (65),
applying (S40) electrons to the reaction chamber to dissociate the precursor gas and create reactive species, and
depositing (S50) a film on the substrate (65) by reacting the reactive species with the substrate (65), wherein the substrate (65) has a positive substrate voltage.

2. The method of claim 1, further comprising:
introducing (S30) at least one reactive background gas into the reaction chamber containing the substrate (65).

3. The method of claim 1, wherein the method is a method for depositing a silicon film, comprising:
conducting electron-enhanced chemical vapor deposition with at least one Si precursor, at least one reactive background gas, and electrons to deposit the silicon film on the substrate (65) with the positive substrate voltage.

4. The method of claim 3, wherein the at least one Si precursor comprises Si₂H₆.

5. The method of claim 3 or 4, wherein the at least one reactive background gas comprises H₂.

6. The method of claim 1, wherein the method is a method for depositing a germanium film, comprising:
conducting electron-enhanced chemical vapor deposition with at least one Ge precursor, at least one reactive background gas, and electrons to deposit the germanium film on the substrate (65) with the positive substrate voltage.

7. The method of claim 6, wherein the at least one Ge precursor comprises GeH₄.

8. The method of claim 6 or 7, wherein the at least one Ge precursor comprises Ge₂H₆.

9. The method of any one of claims 6 to 8, wherein the at least one reactive background gas comprises H₂.

10. The method of claim 1, wherein the method is a method for depositing a compound semiconductor film, comprising:
conducting electron-enhanced chemical vapor deposition with at least two hydride precursors, at least one reactive background gas, and electrons to deposit the compound semiconductor film on the substrate (65) with the positive substrate voltage.

11. The method of claim 10, wherein the compound semiconductor film is a silicon germanium film.

12. The method of any one of claims 1 to 11, wherein the method is conducted at room temperature.
